(19) Europäisches Patentamt
European Patent Office
Office européen des brevets

(11) Publication number: **0 020 870**
**B1**

(12) **EUROPEAN PATENT SPECIFICATION**

(45) Date of publication of patent specification: **09.03.83**

(51) Int. Cl.³: **G 03 F 7/08**

(21) Application number: **80101463.0**

(22) Date of filing: **20.03.80**

(54) **Lithographic photoresist composition.**

(30) Priority: **18.06.79 US 48940**

(43) Date of publication of application:
**07.01.81** ***Bulletin 81/1***

(45) Publication of the grant of the patent:
**09.03.83 Bulletin 83/10**

(84) Designated Contracting States:
**DE FR GB IT**

(56) References cited:
**GB - A - 1 356 390**
**US - A - 3 046 111**
**US - A - 4 065 306**

**J. Org. chem. Vol. 42, No. 17, page 2931 (1977)**

(73) Proprietor: **International Business Machines Corporation**
**Armonk, N.Y. 10504 (US)**

(72) Inventor: **Balanson, Richard David**
**16495 Jackson Oaks Drive**
**Morgan Hill California 95037 (US)**
Inventor: **Clecak, Nicholas Jeffries**
**863 Hampswood Way**
**San Jose, California 95120 (US)**
Inventor: **Grant, Barbara Dianne**
**1503 Huddersfield Court**
**San Jose, California 95126 (US)**
Inventor: **Ouano, Augustus Ceniza**
**343, Pineridge Street**
**Santa Cruz, California 95060 (US)**

(74) Representative: **Chaudhry, Mohammad Saeed**
**IBM United Kingdom Patent Operations Hursley Park**
**Winchester Hants, S021 2JN (GB)**

**EP 0 020 870 B1**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England

# Lithographic photoresist composition

The present invention relates to a lithographic resist composition sensitive to light of less than 3000Å wavelength in the deep ultra-violet region.

The material known as Meldrum's diazo is well known in the art. Its synthesis is shown in CHEM. BER *94* 929 (1961). The systematic chemical name for the material is 2,2-dimethyl-4,6-diketo-5-diazo-1,3-dioxane and its formula is

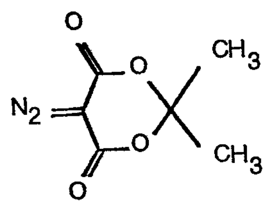

The solution photochemistry of Meldrum's diazo has been previously studied. J. Org. Chem. *42* 2931 (1977).

U.S. Patents 3,046,110 to 3,046,124 inclusive all are concerned with light sensitive printing plates using certain specified diazide sensitizers.

U.S. Patents 3,852,771, 3,961,100 and 4,065,306 are all concerned with use of certain diazide sensitizers in materials to be subjected to electron beams.

A study of factors influencing dissolution of irradiated resist is reported in Polymer Engineering and Science, Vol. 18, No. 4, p. 306 (1978).

According to the invention there is provided a lithographic resist composition comprising a phenolic-aldehyde resin and a sensitizer, characterized in that said sensitizer is a compound having the formula:

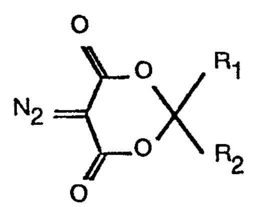

wherein $R_1$ is $C_1$ to $C_{20}$ alkyl or aryl radical, $R_2$ is H, $C_1$ to $C_{20}$ alkyl or aryl radical, or together $R_1$ and $R_2$ are cycloalkyl radical.

The resists in the present invention possess several desirable properties representing advantages over the prior art. They are easily handled in ordinary light. This is in contrast to other resists which must be worked with in the absence of ordinary ambient light. Furthermore, the resists of the present invention are thermally stable and offer significant improvement of resolution because shorter wavelength light is being used. They possess no absorption of light in the conventional U.V. range (above 3000Å). and hence require no optical filters in order to achieve higher resolution images. This offers a significant sensitivity improvement compared to conventional U.V. resists which are active in the regions both above and below 3000Å. They possess the additional advantage of yielding only volatile products upon decomposition. According to the present invention, Meldrum's diazo or a suitable analog is used in resists which comprise a resin of the phenolic-aldehyde type. Many such resins are known in the art. In particular, mention may be made of phenolformaldehyde resin and cresol-formaldehyde resin.

It is still an additional advantage of the present invention that the resists may be formed readily by dissolving the resin and sensitizer in a common solution and casting a film onto an appropriate substrate. Upon imagewise irradiation with ultra-violet light, the sensitizer gives rise to gaseous volatile products in the irradiated regions. The solubility of the film in the exposed regions is thereby increased relative to the unexposed regions. Such photodecomposition can conveniently be brought about with a medium pressure mercury light source or any other source having appreciable intensity at or near 2600Å.

The composition of the present invention may be varied depending upon the particular application desired. In general, the sensitizer is present in from about 5 to 50% of the weight of the resin.

Casting solvents suitable for use in the present invention include, for example, such conventional solvents as diglyme, methyl isobutylketone and the like.

Following imagewise exposure to ultra-violet light, development takes place in the conventional manner, that is, treatment with aqueous alkaline development, for example, potassium hydroxide solution.

A resist formulation was made from 0.71 grams of Meldrum's diazo and 1.64 grams of Varcum resin (Varcum is a Trademark of Reichold Chem. Co. for its Cresol-formaldehyde resin). The mixture of these ingredients was dissolved in 3.72 grams of methyl isobutylketone. Films were cast on silicon wafers which were then pre-baked at 80°C to a thickness of approximately 1.5$\mu$. The films were exposed through a quartz mask and developed with dilute aqueous potassium hydroxide. Extremely fine line resolution in the order of about 2$\mu$ was obtained. Line resolution appears to be limited by factors other than the resist composition.

## Claims

1. A lithographic resist composition

comprising a phenolic-aldehyde resin and a sensitizer, characterised in that said sensitizer is a compound having the formula

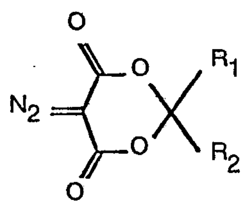

wherein $R_1$ is $C_1$ to $C_{20}$ alkyl or aryl radical, $R_2$ is H, $C_1$ to $C_{20}$ alkyl or aryl radical, or together $R_1$ and $R_2$ are cycloalkyl radical.

2. A composition as claimed in claim 1, in which the sensitizer is present in an amount of from 5 to 50% by weight of the resin.

3. A composition as claimed in claim 1, in which the resin is a cresol-formaldehyde resin.

**Patentansprüche**

1. Lithographische Resistzusammensetzung, die ein Phenol-Aldehydharz und einen Sensibilisator enthält, dadurch gekennzeichnet, daß der Sensibilisator eine Verbindung mit der allgemeinen Formel

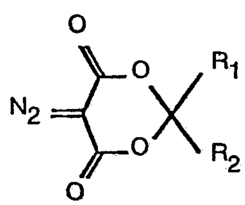

ist, in der $R_1$ einen $C_1$ bis $C_{20}$-Alkyl- oder Arylrest; $R_2$ Wasserstoff oder einen $C_1$ bis $C_{20}$-Alkyl oder Arylrest bedeuten; oder $R_1$ und $R_2$ gemeinsam einen Cycloalkylrest darstellen.

2. Resistzusammensetzung nach Anspruch 1, dadurch gekennzeichnet, daß der Sensibilisatorgehalt 5 bis 50% des Harzgewichts beträgt.

3. Resistzusammensetzung nach Anspruch 1, dadurch gekennzeichnet, daß das Harz ein Kresol-Formaldehydharz ist.

**Revendications**

1. Composition de résist pour traitement lithographique comprenant une résine phénolique-aldéhyde et un sensibilisateur, caracterisée en ce que ledit sensibilisateur est un composé dont la formule est la suivante:

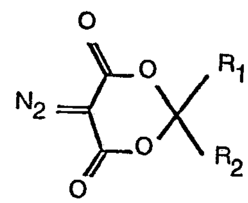

dans laquelle $R_1$ est un radical alcoyle ou aryle $C_1$ à $C_{20}$, $R_2$ est un radical alcoyle ou aryle H, $C_1$ à $C_{20}$, ou $R_1$ et $R_2$ ensemble sont un radical cycloalcoyle.

2. Composition selon la revendication 1 dans laquelle le sensibilisateur est présent dans une quantité de 5 à 50% en poids de la résine.

3. Composition selon la revendication 1 dans laquelle la résine est une résine crésol-formaldéhyde.